# EUROPÄISCHE PATENTSCHRIFT

(11) **EP 4 097 491 B1**
(45) Veröffentlichungstag und Bekanntmachung des Hinweises auf die Patenterteilung: **01.01.2025**
(21) Anmeldenummer: 21700969.5
(22) Anmeldetag: 22.01.2021
(51) Int. Cl.: G01R 25/00, G01R 19/14

(54) **STROMMESSUMFORMER ZUM MESSEN DES DURCH EINEN ELEKTRISCHEN LEITER FLIESSENDEN STROMS UND VERFAHREN ZUR AUSGABE VON MESSWERTEN BEI EINEM STROMMESSUMFORMER MIT AUSGABE DER ENERGIEFLUSSRICHTUNG BEI WECHSELSTRÖMEN**
CURRENT TRANSDUCER FOR MEASURING THE CURRENT FLOWING THROUGH AN ELECTRICAL CONDUCTOR, AND METHOD FOR OUTPUTTING MEASURED VALUES IN A CURRENT TRANSDUCER WITH OUTPUT OF THE ENERGY FLOW DIRECTION FOR ALTERNATING CURRENTS
CONVERTISSEUR DE MESURE DE COURANT DESTINÉ À MESURER LE COURANT CIRCULANT DANS UN CONDUCTEUR ÉLECTRIQUE ET PROCÉDÉ POUR DÉLIVRER DES VALEURS DE MESURE SUR UN CONVERTISSEUR DE MESURE DE COURANT AVEC FOURNITURE DU SENS DE CIRCULATION DE L'ÉNERGIE DANS LE CAS DE COURANTS ALTERNATIFS

(30) Priorität: 30.01.2020 LU 101628
(43) Veröffentlichungstag der Anmeldung: 07.12.2022
(73) Patentinhaber: PHOENIX CONTACT GmbH & Co. KG, 32825 Blomberg Nordrhein-Westfalen (DE)
(72) Erfinder: JANKOWSKI, Martin, 30926 Seelze Niedersachsen (DE)
(74) Vertreter: LifeTech IP Spies & Behrndt Patentanwälte PartG mbB
(86) Internationale Anmeldenummer: PCT/EP2021/051419
(87) Internationale Veröffentlichungsnummer: WO 2021/151785

(56) Entgegenhaltungen:
- EP-A1- 3 252 907
- CN-A- 110 224 491
- DE-C- 837 563
- DE-T5- 112014 002 840
- WIKIPEDIA: "Blindleistung", 23 February 2018 (2018-02-23), XP055493525, Retrieved from the Internet <URL:https://de.wikipedia.org/w/index.php?title=Blindleistung&oldid=174302273> [retrieved on 20180718]
- KAMBER W: "ScheinleistungszÃ hler", BULL. SEV/VSE,, vol. 66, no. 24, 20 December 1975 (1975-12-20), pages 1341 - 1346, XP001457184
- PAUL KOENIG: "Eine Methode zur Messung des Leistungsfaktors in Bahnnetzen", TECHN. MITT. AEG-TELEFUNKEN,, vol. 64, no. 7, 1 January 1974 (1974-01-01), pages 257 - 259, XP001456616

## Beschreibung

Die Erfindung betrifft einen Strommessumformer zum Messen des durch einen elektrischen Leiter fließenden Stroms. Der Vorschlag betrifft weiterhin ein Verfahren zur Ausgabe von Messwerten bei einem Strommessumformer mit Ausgabe der Energieflussrichtung bei Wechselströmen.

Bei den bekannten Strommessumformern für Wechselströme wird typischerweise ausschließlich der Wert der Stromstärke proportional ausgeben.

Es gibt Energiemessgeräte, die zwar die Richtung des Energieflusses ermitteln können und auch anzeigen können, nicht aber den proportionalen Strom ausgeben können.

Das Dokument CN 110 224 491 A offenbart eine Überwachungsvorrichtung für einen automatischen Schalter eines verteilten Energieverteilungsnetzes.

Das Dokument DE 11 2014 002840 T5 lehrt einen Leistungsmesser, der für jeden Stromwandler CT elektrische Energie misst, die an eine Einrichtung bereitgestellt wird, oder elektrische Energie, die von der Einrichtung bereitgestellt wird, auf der Grundlage eines von einem Strommesser gemessenen Stroms und einer von einem Spannungsmesser gemessenen Spannung.

Das Dokument US2009315566A1 betrifft einen AC Stromsensor, der ein pulsförmiges Ausgangssignal erzeugt, mit dem sowohl Phasenwinkel und Polarität angegeben werden kann, woraus sich auch die Energieflussrichtung bestimmen lässt. Die Stromstärke wird von einer Lampe (LED) angezeigt, indem diese mit den erzeugten Pulsen angesteuert wird. Ein helleres Leuchten zeigt dann einen stärkeren Stromfluss an. In einer Ausführungsart wird auch die Energieflussrichtung digital ausgegeben und angezeigt. Dieser Sensor kann so eine Anzeige liefern, bei welcher Energieflussrichtung relativ zum Stromsensor z.B. ein fraglicher Kurzschluss aufgetreten ist, weil die hiermit bereitgestellte Richtungsanzeige in der kurz vor dem Kurzschluss bereitgestellten Messzeitspanne registriert wird.

Die bekannte Lösung hat allerdings den Nachteil, dass Stromstärke und Energieflussrichtung so nicht auf eine Steuerungseinheit gegeben werden können um eine Maschine oder einen Prozess zu steuern.

Es besteht deshalb der Bedarf für einen verbesserten Strommessumformer, der diese Nachteile vermeidet. Dies wurde im Rahmen der Erfindung erkannt.

Diese Aufgabe wird durch einen Strommessumformer zum Messen des durch einen elektrischen Leiter fließenden Stroms gemäß Anspruch 1, und ein Verfahren zur Ausgabe der Stromstärke bei einem solchen Strommessumformer gemäß Anspruch 9 gelöst.

Die abhängigen Ansprüche beinhalten vorteilhafte Weiterbildungen und Verbesserungen der Erfindung entsprechend der nachfolgenden Beschreibung dieser Maßnahmen.

Die Erfindung beschreibt einen Strommessumformer, der einen Eingang hat, an dem ein Primärwechselstrom gemessen werden kann. Dazu ist ein geeigneter Stromsensor verbaut. Zudem enthält der Strommessumformer eine geeignete Energieflussrichtungserkennung, die es zulässt die Stromrichtung des Primärwechselstroms zu detektieren. Eine geeignete Verarbeitungseinheit kombiniert aus der Höhe des Primärwechselstroms und der Energieflussrichtung ein analoges Ausgangssignal, welches sowohl positive als auch negative Werte annehmen kann.

Der erfindungsgemäße Strommessumformer beinhaltet einen Stromsensor, der die Stromstärke durch den elektrischen Leiter erfasst und eine Auswerteeinrichtung zur Auswertung der mit dem Stromsensor erfassten Messwerte, und zur Energieflussrichtungsbestimmung. In Abhängigkeit der bestimmten Energieflussrichtung erfolgt bei dem erfindungsgemäßen Strommessumformer eine Ausgabe der Stromstärke in einem positiven oder negativen Ausgangsstrom. Gegenüber den bekannten Strommessumformern ergibt sich der Vorteil, dass auch die Energieflussrichtung miterfasst wird und eine Ausgabe so gestaltet wird, dass Energieflussrichtung und Stromstärke gleichzeitig ausgegeben werden. Eine Steuerungseinheit kann dieses Ausgabesignal erfassen und die Maschine oder den Prozess entsprechend steuern oder regeln.

In vorteilhafter Weise beinhaltet der Strommessumformer weiterhin einen Spannungsmesser, wobei der Spannungsmesser zur Ermittlung der Phasenlage die Spannungshöhe der Spannung auf dem elektrischen Leiter erfasst. Dann ist es vorteilhaft, wenn die Bestimmung der Energieflussrichtung durch Auswertung der Messwerte von Strom und Spannung auf dem Leiter durch die Auswerteeinrichtung so erfolgt, dass eine Phasenverschiebungswinkel-bestimmung für die Phasenverschiebung zwischen Spannung und Strom erfolgt. Damit wird dann ein Ausgangssignal erzeugt, bei dem eine Ausgabe der Stromstärke in dem positiven Ausgabebereich erfolgt, wenn der Phasenverschiebungswinkel im Bereich von -90° bis +90° liegt und anderenfalls eine Ausgabe der Stromstärke in dem negativen Ausgabebereich erfolgt. Durch Bestimmung des Phasenverschiebungswinkels lässt sich die Energieflussrichtung einfach ermitteln.

In einer bevorzugten Ausführungsform des Strommessumformers erfolgt die Ausgabe der Stromstärke in dem positiven und negativen Ausgabebereich proportional, wobei der jeweilige Ausgabebereich so definiert ist, dass der Ausgangsstrom proportional zum Messstrom durch den Nullpunkt läuft.

Dabei kann die Auswerteeinrichtung das Ausgabesignal für den erfassten Messstrom so erzeugen, dass entlang der Ordinate entsprechend der bestimmten Energieflussrichtung die Ausgabewerte vorzeichenbehaftet ausgebbar sind. Das Ausgabesignal kann einem analogen Gleichstromsignal entsprechen. Die Energieflussrichtung bestimmt dabei die Stromrichtung.

In einer anderen Variante erfolgt die Ausgabe des Messstroms immer positiv, also mit der gleichen Stromrichtung und die Energieflussrichtung wird über einen weiteren Ausganganschluss ausgegeben.

Bei dieser Variante kann es zusätzlich vorgesehen werden, dass die Ausgabe des Messstroms immer positiv erfolgt und die Energieflussrichtung über den weiteren Ausganganschluss ausgegeben wird und das Ausgabesignal zusätzlich einen Offsetwert aufweist. Dieser kann in einem bevorzugtem Beispiel 4 mA betragen.

Zur besseren Information des Bedienpersonals ist es vorteilhaft, wenn der Strommessumformer mit zwei zusätzlichen Anzeigeelementen, insbesondere Leuchtdioden, ausgestattet ist, die zur Anzeige der Energieflussrichtung dienen.

Die Erfindung besteht in einer anderen Ausprägung in einem Verfahren zur Ausgabe von Messwerten bei einem Strommessumformer bei dem neben der Stromstärke die Energieflussrichtung des durch den elektrischen Leiter fließenden Wechselstroms gemessen wird, und die Stromstärke in Abhängigkeit der bestimmten Energieflussrichtung in einem positiven oder negativen Ausgabebereich einer Ausgabeeinheit ausgegeben wird.

Dafür ist es vorteilhaft, wenn eine Messung der Spannungshöhe der Spannung auf dem elektrischen Leiter durchgeführt wird und die Bestimmung der Energieflussrichtung durch Auswertung der Messwerte von Strom und Spannung durchgeführt wird, wobei eine Phasenverschiebungswinkelbestimmung für die Phasenverschiebung zwischen Spannung und Strom durchgeführt wird und die Stromstärke in dem positiven Ausgabebereich ausgegeben wird, wenn der Phasenverschiebungswinkel im Bereich von 90° bis +90° liegt und anderenfalls die Stromstärke in dem negativen Ausgabebereich ausgegeben wird.

Soll der gemessene Primärstrom ohne die Polaritätsumschaltung am Ausgang erfolgen, kann die Polarität durch einen weiteren Ausgang ausgegeben werden.

Der Normstrom kann dabei 0-20mA oder 4-20mA betragen.

Dabei ist es weiterhin vorteilhaft, wenn zusätzlich zur Strommessung eine Messung der Spannungshöhe der Spannung auf dem elektrischen Leiter durchgeführt wird und über S = U·I die Scheinleistung S ermittelt werden kann. Diese kann dann proportional zur Messung des Stromes ausgegeben werden. Mit dem bestimmten Phasenverschiebungswinkel ϕ ist es möglich über den bestimmten Wirkfaktor cos ϕ und den bestimmten Blindfaktor sin ϕ auch die Wirk- und Blindleistung zu bestimmen und auszugeben. Die Formel für die Wirkleistung P lautet P = S·cos ϕ und die Formel für die Blindleistung Q_{L} lautet Q_{L} = S·sin ϕ. Dafür werden verschiedene Varianten erwähnt. Dabei wird als Ausgabeeinheit ein Analog-Ausgang eines Mikrocontrollers eingesetzt über den ein Normstrom im Bereich von z.B. 0-20 mA ausgegeben wird oder eine Normspannung im Bereich von z.B. -10 V ... +10 V oder von 0-10 V ausgegeben.

In einer Variante wird der Strom durch den Strommessumformer gemessen und die Spannung mit einem Spannungsmesser, wobei statt der Ausgabe des gemessenen Stroms eine Ausgabe in Form einer Spannung proportional zum gemessenen Strom erfolgt.

Bei einer anderen Variante wird wieder der Strom durch den Strommessumformer gemessen und die Spannung mit einem Spannungsmesser, wobei statt der Stromstärke die bestimmte Wirkleistung in dem positiven und negativen Ausgabebereich der Ausgabeeinheit ausgegeben wird.

Bei der nächsten Variante wird wieder der Strom durch den Strommessumformer gemessen, und die Spannung mit einem Spannungsmesser, wobei statt der Stromstärke die bestimmte Blindleistung in dem positiven und negativen Ausgabebereich der Ausgabeeinheit ausgegeben wird.

Bei einer weiteren Variante wird wieder der Strom durch den Strommessumformer gemessen, und die Spannung mit einem Spannungsmesser, wobei statt der Stromstärke die bestimmte Scheinleistung in dem positiven Ausgabebereich der Ausgabeeinheit ausgeben wird.

Bei einer anderen Variante wird wieder der Strom durch den Strommessumformer gemessen, und die Spannung mit einem Spannungsmesser, wobei statt der Stromstärke der bestimmte Leistungsfaktor oder der bestimmte Phasenverschiebungswinkel in dem positiven und negativen Ausgabebereich der Ausgabeeinheit ausgegeben wird.

Bei einer anderen Variante wird wieder der Strom durch den Strommessumformer gemessen und statt der Stromstärke die bestimmte Frequenz in dem positiven Ausgabebereich der Ausgabeeinheit ausgegeben.

Es versteht sich dabei, dass der höchste Leistungsfaktor, oder die höchste zu messende Frequenz dem höchsten auszugebenden Strom, z.B. 20 mA entspricht oder der höchsten auszugebenden Spannung, z.B. 10 V entspricht.

Das gilt auch für den Phasenverschiebungswinkel in gleicher Weise, nur dass der Phasenverschiebungswinkel auch vorzeichenbehaftet ausgegeben wird.

Mehrere Ausführungsbeispiele der Erfindung sind in den Zeichnungen dargestellt und werden nachfolgend anhand der Figuren näher erläutert.

Es zeigen:
- Fig. 1: ein erstes Blockschaltbild eines Strommessumformers zum Messen des durch einen elektrischen Leiter fließenden Stroms;
- Fig. 2: einen Schaltplan zur Erläuterung des Verhaltens eines Wechselstroms bei Vorhandensein einer Induktivität;
- Fig. 3: ein Signaldiagramm mit den Stromverläufen an Wirk- und Blindwiderstand und dem Spannungsverlauf bei der Schaltung nach Fig. 2;
- Fig. 4: ein zweites Blockschaltbild eines Strommessumformers zum Messen des durch einen elektrischen Leiter fließenden Stroms;
- Fig. 5: ein erstes Ausführungsbeispiel einer Ausgabe von Stromstärke und Energieflussrichtung in analoger Form bei dem erfindungsgemäßen Strommessumformer;
- Fig. 6: ein zweites Ausführungsbeispiel einer Ausgabe von Stromstärke und Energieflussrichtung in analoger Form bei dem erfindungsgemäßen Strommessumformer;
- Fig. 7: ein drittes Ausführungsbeispiel einer Ausgabe von Stromstärke und Energieflussrichtung in analoger Form bei dem erfindungsgemäßen Strommessumformer; und
- Fig. 8: ein Flussdiagramm für einen Auswertealgorithmus zur Ermittlung der Energieflussrichtung und zur Aufbereitung der Daten für eine analoge Ausgabe von Stromstärke und Energieflussrichtung.

Die vorliegende Beschreibung veranschaulicht die Prinzipien der erfindungsgemäßen Offenbarung. Es versteht sich somit, dass Fachleute in der Lage sein werden, verschiedene Anordnungen zu konzipieren, die zwar hier nicht explizit beschrieben werden, die aber Prinzipien der erfindungsgemäßen Offenbarung verkörpern und in ihrem Umfang ebenfalls geschützt sein sollen.

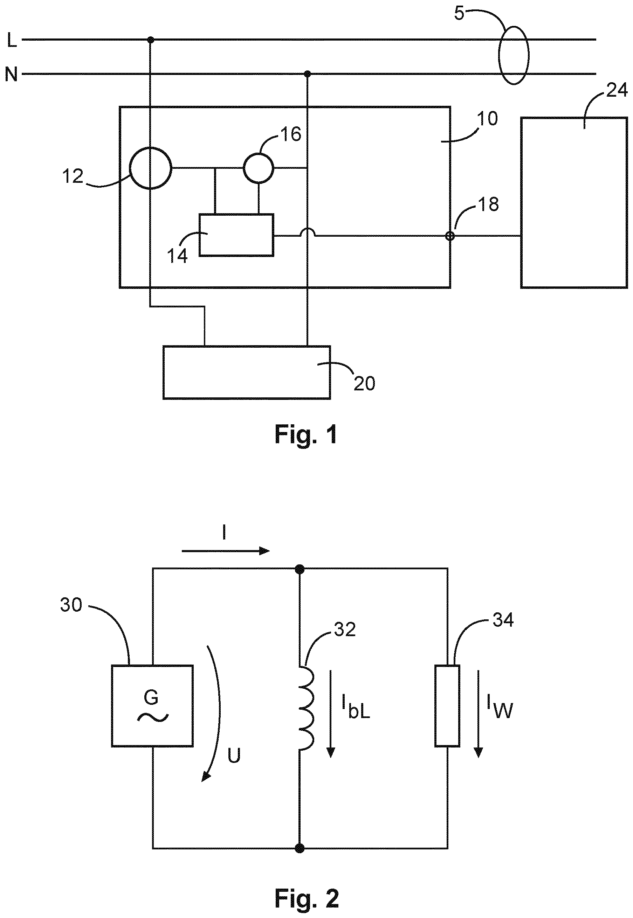

Fig. 1 zeigt ein Blockschaltbild eines Strommessumformers 10 zum Messen des durch einen elektrischen Leiter L fließenden Stroms. Gezeigt ist ein einphasiges Kabel 5 bestehend aus Phase L und Neutralleiter N. Optional kann auch noch ein Schutzleiter in dem Kabel 5 enthalten sein (nicht gezeigt). Es soll der Strom auf dem Leiter L überwacht werden. Dazu wird ein Strommessumformer 10 eingesetzt. Der wird zwischen Phase L und Neutralleiter N geschaltet. Der Strom wird bei dieser Variante intern durch den Strommessumformer 10 geleitet. Bei einem anderen Typ eines Strommessumformers wird der Strom nicht durch den Strommessumformer geleitet, sondern indirekt bestimmt. Dazu kann z.B. ein Strommessumformer 10 mit Rogowski-Spule eingesetzt werden. Das ist eine Luftspule, die um den Leiter L gelegt wird. Die Wirkung des sich ändernden Magnetfeldes, das um den Leiter L bei Wechselstrom entsteht ist so, dass eine Spannung in der Rogowski-Spule induziert wird, die gemessen wird.

Bei dem dargestellten Strommessumformer 10 bezeichnet die Bezugszahl 12 einen Stromsensor. Dieser erfasst den durch den Leiter L fließenden Strom quantitativ. Der Strommessumformer 10 ist auch an den Neutralleiter N angeschlossen. Beide Leiter, Phase L und Neutralleiter N sind an Ausgängen wieder herausgeführt an die die Last 20 angeschlossen wird. Typische Stromsensoren, oft auch als Stromwandler bezeichnet sind Transformatoren, kleiner Leistung, die hohe Ströme in leicht messbare Werte transformieren. In einer Variante wird die Eingangswicklung in den Leiter der Phase L geschaltet und wird von dem zu messenden Strom durchflossen. An die Ausgangswicklung wird z.B. ein konventioneller Strommesser (Ampere-Meter) angeschlossen. Dadurch, dass die Primärwicklung nur wenige Windungen oder sogar nur eine Windung aufweist, die Sekundärwicklung hingegen eine wesentlich größere Zahl von Windungen, können hohe Stromwerte von einigen Hundert Ampere mit konventioneller Messtechnik (Ampere-Metern) erfasst werden. Eine andere Variante von Stromsensoren sind sogenannte Durchsteck-Stromwandler, durch die der Leiter, dessen Strom erfasst werden soll, hindurch gesteckt wird. Dazu gehören auch die Rogowski-Spulen. Damit können sogar noch höhere Stromwerte erfasst werden. Dies ist vorteilhaft für Leiter, die z.B. Stromschienen betreffen, die aber nicht mehr mit geringem Aufwand gewickelt werden können. Eine dritte Variante von Stromsensoren 12, die ebenfalls bei der beschriebenen Vorrichtung einsetzbar sind, sind Halleffekt-Stromsensoren. Bei diesen wird der Hall-Effekt ausgenutzt, der darin besteht, dass in einem stromdurchflossenen Leiter, der sich in einem stationären Magnetfeld befindet, eine elektrische Spannung generiert wird. Solche Hall-Generatoren werden typischerweise flächig ausgeführt, wobei ein möglichst homogenes Magnetfeld erzeugt wird, das senkrecht zu dem flächigen Leiter ausgerichtet ist. Die Hall-Spannung wird an den äußeren Rändern des flächigen Leiters quer zur Stromrichtung abgegriffen. Der Halleffekt-Stromsensor wird dazu in einer Variante in einen geschlitzten magnetischen Ringkern gesteckt.

Die Messwerte werden von der Auswerteelektronik 14 der Vorrichtung erfasst und für die Auswertung zwischengespeichert. Die Auswerteelektronik 14 kann als Mikrocontroller ausgeführt sein. Dieser ist mit A/D-Wandler und Abtasteinheit ausgestattet, um aufeinanderfolgende Messwerte zu erfassen. Er beinhaltet ebenfalls einen Speicher (z.B. CMOS-RAM-Speicher), um die Messwerte zwischen zu speichern. Die Hauptkomponente ist ein Mikrorechner, der programmierbar ist und den Auswertealgorithmus ausführt. Der Mikrorechner beinhaltet auch eine D/A-Wandlereinheit, die ein analoges Ausgangssignal erzeugt.. Die Ausgabeeinheit wird so bevorzugt durch eine integrierte D/A-Wandlereinheit in einem Mikrorechner realisiert. Das analoge Ausgangssignal wird über den Ausgangsanschluss 18 ausgegeben. Eine separate Leitung kann an diesen Ausgangsanschluss 18 angeschlossen werden und leitet dieses Signal an eine Steuerungseinrichtung 24 weiter. Z.B. kann das Signal an eine speicherprogrammierbare Steuerung SPS 24 geleitet werden. Die Messwerteerfassung erfolgt mit einer bestimmten Abtastrate, die im Bereich von kS/s liegen kann. Was durch die Auswerteelektronik 14 ebenfalls erfasst wird, ist die Spannung zwischen Phase L und Neutralleiter N. Dazu ist ein Spannungsmesser 16 an Phase L und Neutralleiter N angeschlossen. Die gemessenen Spannungswerte werden von der Auswertelektronik 14 übernommen und in den Speicher geschrieben.

Die Energieflussrichtung wird durch den Strommessumformer 10 ebenfalls bestimmt. Dies geschieht durch Bestimmung der Phasenlage des Strom relativ zur Spannung. Zur Verdeutlichung des Messprinzips ist in Fig. 2 eine Schaltung gezeigt. Der Wechselstromgenerator hat die Bezugszahl 30. Der Stromfluss I ist in einer Richtung gezeigt. Die Last 20 besteht in der gezeigten Schaltung aus einer Spule 32 und einem ohmschen Widerstand 34. Der Strom I teilt sich entsprechend auf in einen Anteil I_{bl}. und einen Anteil I_{w}. Wie bekannt, wirkt die Spule 32 wie ein Blindwiderstand, führt aber zu einer Phasenverschiebung zwischen Spannung U und Strom I.

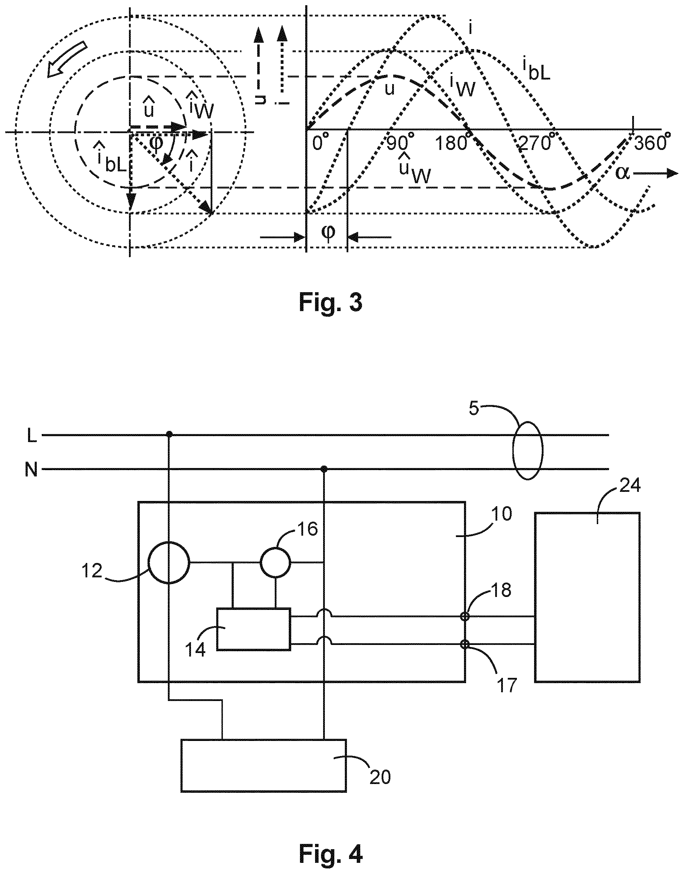

Die genauen Signalverläufe sind in der Fig. 3 gezeigt. Auf der linken Seite ist das Zeigerdiagramm gezeigt und auf der rechten Seite die Signalverläufe. Die Scheitelwerte von Spannung û, Strom î_{bl} durch die Spule 32 und Strom î_{w} durch den ohmschen Widerstand 34 sind im Zeigerdiagramm als die entsprechenden Zeigerlängen dargestellt. Es resultiert in der Überlagerung der Gesamtstrom i, dessen Signalverlauf ebenfalls zu sehen ist. Die Phasendifferenz ϕ zwischen Spannung u und Strom i ist in beiden Teilen der Fig. 3 eingezeichnet. Es ergibt sich durch die konkrete Beschaltung eine Phasendifferenz ϕ von ca. 40°. Die Phasendifferenz ϕ kann so ermittelt werden, dass die Signalverläufe von u und i ausgewertet werden. Es wird in beiden Fällen der aufsteigende Nulldurchgang der Signalverläufe von u und i bestimmt. Die zeitliche Differenz wird dann in Beziehung zur Periodendauer T gesetzt um die Phasendifferenz ϕ zu ermitteln.

Die Energieflussrichtung ergibt sich dabei wie folgt: Wenn die Phasendifferenz zwischen u und i bei 90° und +90° liegt, ist die Energieflussrichtung als positiv definiert, also von dem Generator 30 zur Last 20. In den anderen Fällen ist sie negativ definiert, also von der Last 20 zu dem Generator 30.

Die Fig. 4 zeigt eine zweite Variante des Strommessumformers 10. Gleiche Bezugszahlen bezeichnen die gleichen Komponenten. Ein Unterschied besteht darin, dass zwei Ausgangsleitungen aus dem Strommessumformer 10 herausgeführt sind. Die eine Ausgangsleitung führt zum Ausgangsanschluss 18. Die andere Ausgangsleitung führt zum Ausgangsanschluss 17. Die Leitung an Ausgangsanschluss 18 ist wieder an einen D/A-Ausgang des Mikrorechners angeschlossen. Die andere Ausgangsleitung zum Ausgangsanschluss 17 kann ebenfalls an einen D/A-Ausgang des Mikrorechners angeschlossen werden. In einer anderen Variante kann die Ausgangsleitung alternativ an einen Digitalausgang des Mikrorechners angeschlossen werden. Es führen dabei also zwei Ausgangsleitungen zu der Steuerungseinrichtung 24.

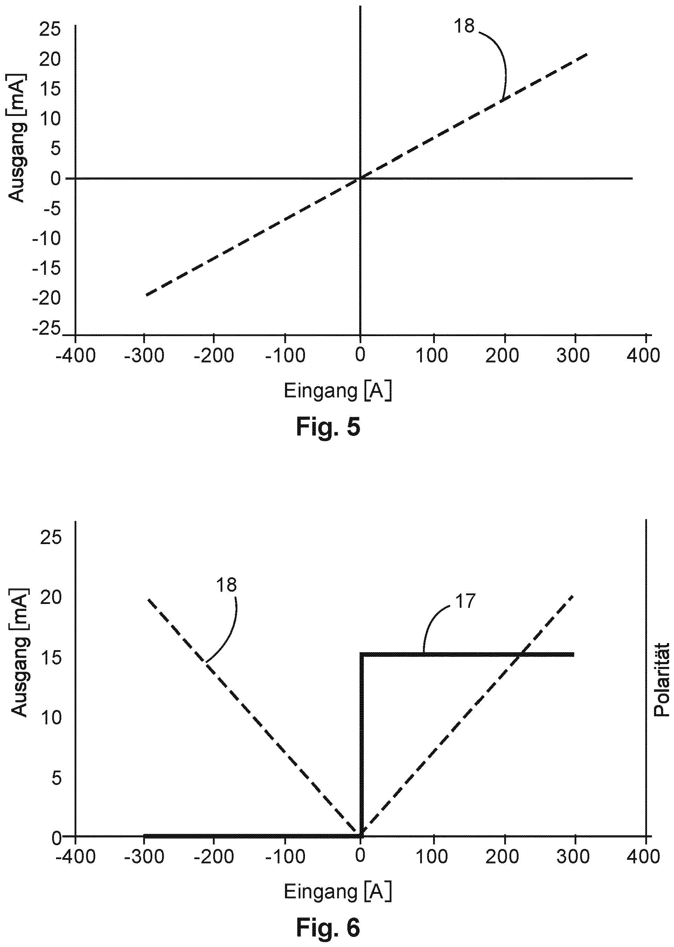

Fig. 5 zeigt jetzt eine kombinierte Variante einer analogen Ausgabe der gemessenen Stromstärke und der Energieflussrichtung. Die Darstellung des analogen Ausgangssignals erfolgt in Form eines Sekundärstrom- zu Primärstrom-Diagramms. Der Primärstrom entspricht dem Strom durch den Leiter L und ist in Fig. 5 von -400 A bis +400 A angegeben. Der Sekundärstrom ist der Strom, der in der Auswerteeinrichtung 14 gemessen wird und liegt im Bereich von -25 mA bis +25 mA. Im dargestellten Fall ergibt sich ein Scheitelwert von ca. 20 mA. Dieser Wert entspricht einem Primärstrom von ca. 300 A. Die Umrechnung erfolgt direkt proportional. Die Ausgabe der Stromstärke erfolgt in analoger Form, wie dargestellt, unter Berücksichtigung der Energieflussrichtung. Also, wenn die Energieflussrichtung als positiv bestimmt wurde, erfolgt die Ausgabe in Form der Geraden in dem ersten Quadranten des Koordinatensystems. Es wird ein Gleichstrom ausgegeben. Dessen Stromfluss ist damit in Richtung von der Auswerteelektronik 14 zur Steuerung 24. Umgekehrt, wenn die Energieflussrichtung als negativ bestimmt wurde, erfolgt die Ausgabe in Form der dargestellten Geraden in dem dritten Quadranten des Koordinatensystems. Der Stromfluss ist dann in umgekehrter Richtung von der Steuerung 24 zur Auswerteelektronik 14. Fig. 5 zeigt beide Geraden in Form einer durchgängigen Linie.

Fig. 6 zeigt eine zweite Variante der Ausgabe der gemessenen Stromstärke und der Energieflussrichtung, die für die Variante des Strommessumformers 10 gem. Fig. 4 gültig ist. Dabei wird die Energieflussrichtung nur dadurch angezeigt, dass der zusätzliche Ausgang 17 für den positiven Bereich einen anderen Zustand annimmt als für den negativen Zustand. Für den Sekundärstrom wird in beiden Fällen ein Signal mit positiver Polarität ausgegeben, d.h. die Stromrichtung bleibt gleich.

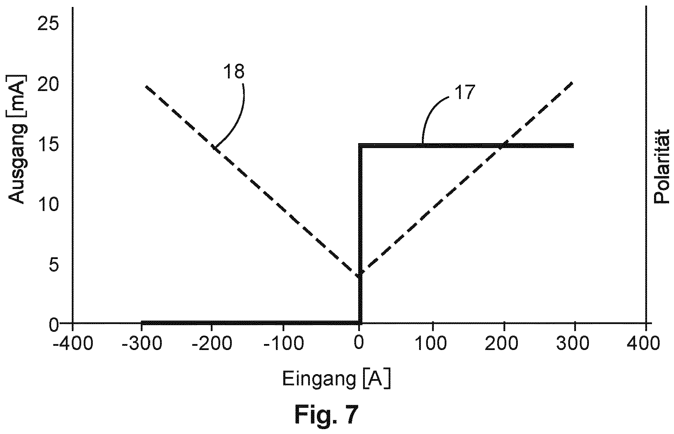

Fig. 7 zeigt ein drittes Ausführungsbeispiel der analogen Ausgabe der gemessenen Stromstärke und der Energieflussrichtung. Dabei wird die Energieflussrichtung wie in Fig. 6 angezeigt. Auch für die Stromstärke des Sekundärstroms werden in beiden Fällen positive Werte angezeigt. Allerdings gehen die Geraden nicht vom Ursprung des Koordinatensystems aus. Stattdessen ist dargestellt, dass ein bestimmter Offset von ca. 4 mA besteht. Die Geraden verlaufen von diesem Offset-Punkt bei 0 A Primärstrom zum aktuell gemessenen Scheitelwertwert î. Diese Form der Ausgabe des Messstroms ermöglicht einen sekundären Stromfluss, obwohl kein Primärstrom fließt. Dadurch kann das Messsystem selbst ohne Primärstrom überwacht werden. Auch das Schaltsignal zur Ausgabe der Polarität ist erneut dargestellt.

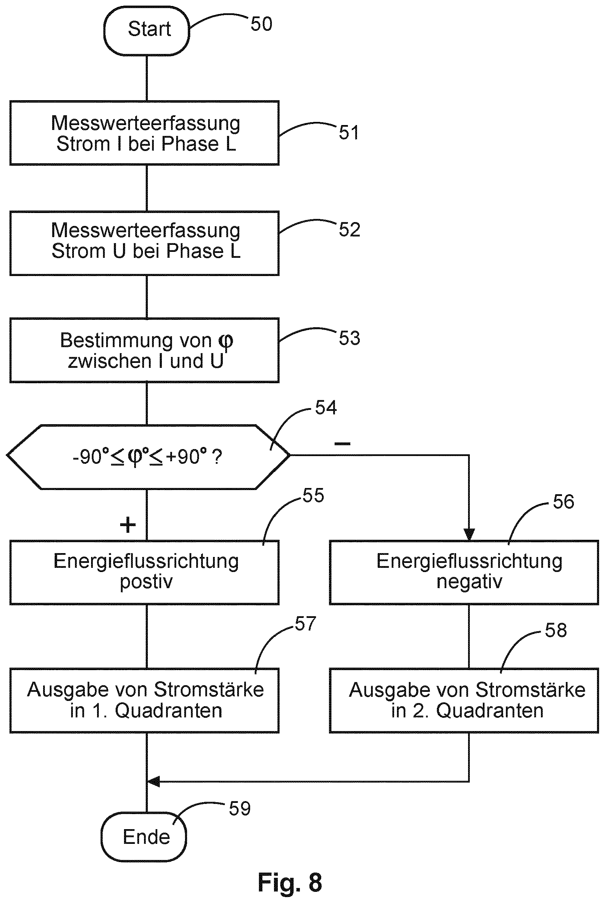

Fig. 8 zeigt ein Ausführungsbeispiel eines Flussdiagramms eines Auswertealgorithmus, der in der Auswerteelektronik 14 abgearbeitet wird. Der Programmstart ist mit der Bezugszahl 50 bezeichnet. Im Programmschritt 51 erfolgt die Messwerterfassung des Stroms durch den Leiter der Phase L. Im Programmschritt 52 erfolgt die Messwerterfassung der Spannung auf dem Leiter der Phase L gegenüber dem Neutralleiter. Dabei werden die vom Stromsensor 12 ausgegebenen Signale auf einen A/D-Eingang des Mikrocontrollers der Auswerteelektronik 14 gegeben. Dieser tastet das Eingangssignal ab und schreibt die Digitalwerte in den Speicher. Ebenfalls wird das Messsignal des Spannungsmessers über einen weiteren A/D-Eingang des Mikrocontrollers abgetastet und die Digitalwerte werden ebenfalls in den Speicher geschrieben. Im Programmschritt 53 erfolgt eine Bestimmung der Phasendifferenz ϕ zwischen Spannung U und Strom I. Die Bestimmung erfolgt so, wie zuvor im Zusammenhang mit der Fig. 3 beschrieben. Es werden die Signalverläufe von U und I ausgewertet. In einer Variante wird bei beiden Signalen der aufsteigende Nulldurchgang der Signalverläufe von U und I bestimmt. Dann wird die zeitliche Differenz zwischen diesen beiden Punkten bestimmt. Diese wird dann in Beziehung zur bestimmten Periodendauer T der Signale gesetzt um die Phasendifferenz ϕ zu ermitteln. Bei Vorhandensein von Induktivitäten folgt der Wechselstrom der Wechselspannung nach. Im Programmschritt 54 erfolgt die Auswertung des festgestellten Phasenverschiebungswinkels ϕ. Liegt ϕ im Bereich von [90°, +90°], wird gefolgert, dass die Energieflussrichtung positiv ist, also Energie vom Wechselstromgenerator 12 in Richtung zur Last 20 fließt. Wird festgestellt, dass der Phasenverschiebungswinkels ϕ außerhalb dieses Bereiches liegt, wird gefolgert, dass die Energieflussrichtung umgekehrt ist, also die Last die Energie liefert und diese zum Kraftwerk zurückfließt. Im Programmschritt 55 wird festgelegt, dass die Energieflussrichtung positiv ist. Dann erfolgt anschließend im Programmschritt 57 die Ausgabe der Ausgangsstromstärke in Abhängigkeit von der Eingangsstromstärke mit der Geraden wie im 1. Quadranten der Fig. 5, der Fig. 6 oder der Fig. 7 gezeigt. Die Energieflussrichtung wird damit ebenfalls angezeigt. Zusätzlich wird das in den Fig. 6 und 7 dargestellte Schaltsignal ausgegeben. Liegt der Phasenverschiebungswinkels ϕ außerhalb des Bereichs von [-90°, +90°] findet in Programmschritt 56 die Festlegung statt, dass die Energieflussrichtung negativ ist. Dementsprechend wird in Programmschritt 58 die Ausgangsstromstärke mit der Geraden wie im 3. Quadranten der Fig. 5, oder im 2. Quadranten der Fig. 6 oder 7 ausgegeben. Auch eine Ausgabe des Schaltsignals am Ausgangsanschluss 17 kann wiederum erfolgen.

Es sollte verstanden werden, dass das vorgeschlagene Verfahren und die zugehörigen Vorrichtungen in verschiedenen Formen von Hardware, Software, Firmware, Spezialprozessoren oder einer Kombination davon implementiert werden können. In einer bevorzugten Variante werden Mikrocontroller mit integriertem RAM-Speicher und integrierten I/O-Schnittstellen eingesetzt. Spezialprozessoren können anwendungsspezifische integrierte Schaltungen (ASICs), Reduced Instruction Set Computer (RISC) und / oder Field Programmable Gate Arrays (FPGAs) umfassen. Vorzugsweise wird das vorgeschlagene Verfahren und die Vorrichtung als eine Kombination von Hardware und Software implementiert. Die Software wird vorzugsweise als ein Anwendungsprogramm auf einer Programmspeichervorrichtung installiert. Typischerweise handelt es sich um eine Maschine auf Basis einer Computerplattform, die Hardware aufweist, wie beispielsweise eine oder mehrere Zentraleinheiten (CPU), einen Direktzugriffsspeicher (RAM) und eine oder mehrere Eingabe/Ausgabe (I/O) Schnittstelle(n). Auf der Computerplattform wird typischerweise außerdem ein Betriebssystem installiert. Die verschiedenen Prozesse und Funktionen, die hier beschrieben wurden, können Teil des Anwendungsprogramms sein oder ein Teil, der über das Betriebssystem ausgeführt wird.

Die Offenbarung ist nicht auf die hier beschriebenen Ausführungsbeispiele beschränkt. Es gibt Raum für verschiedene Anpassungen und Modifikationen, die der Fachmann aufgrund seines Fachwissens als auch zu der Offenbarung zugehörend in Betracht ziehen würde.

In der folgenden Tabelle sind einige Möglichkeiten zusammengestellt für verschiedene Varianten von Eingangsmess- und Ausgabeoptionen für den erfindungsgemäßen Strommessumformer. Dabei werden die Ausgangsoptionen getrennt nach Analog und Digital-Optionen in verschiedenen Spalten aufgelistet.

Die Tabelle 1 ist so zu verstehen, dass alle Eingangsmessoptionen beliebig mit den analogen und digitalen Ausgangsoptionen verknüpft werden können. Also es kann für eine Eingangsmessoption gewählt werden, ob sie in Form einer analogen Stromausgabe oder einer analogen Spannungsausgabe für die Steuerung zur Verfügung gestellt werden soll.

Dabei können verschiedene Ausgabebereiche gewählt werden, z.B. 4 bis 20 mA für die Stromausgabe oder 1 bis 5 V für die Spannungsausgabe. Mit den digitalen Ausgabeoptionen können die in der Tabelle angegebenen Informationen z.B. über entsprechend angesteuerte LED's ausgegeben werden. Die Abkürzung THD steht dabei für Total Harmonic Distortion, die im Rahmen der Signalanalyse einer Angabe entspricht, um die Größe der Anteile, die durch nichtlineare Verzerrungen eines Signals entstehen, zu quantifizieren.

**Tabelle 1**

| **Eingangsmessoptionen** | **Ausgangsoptionen Analog** | **Ausgangsoptionen Digital** |
|---|---|---|
| Effektivwert der Wechselstromstärke | für Stromausgabe | Polarität der Energieflussrichtung |
| Effektivwert der Wechselspannung | 0 bis 20 mA | Polarität des Leitungsfaktors |
| Wirkleistung | 4 bis 20 mA | Polarität der Abweichung vom Sollwert |
| Blindleistung | -20 bis +20 mA | Lasttyp (induktiv/kapazitiv) |
| Scheinleistung | für Spannungsausgabe | |
| Leistungsfaktor | 0 bis 10 V | |
| Frequenz | 2 bis 10 V | |
| Crestfaktor | -10 bis +10 V | |
| THD Strom | 0 bis 5 V | |
| THD Spannung | 1 bis 5 V | |
| Gleichstrom | -5 bis +5 V | |
| Gleichspannung | 0 bis 10 V | |
| Lasttyp (induktiv/kapazitiv) | 2 bis 10 V | |
| Phasenwinkel | | |
| Abweichung vom Sollwert einer der vorgenannten Größen | | |

### Bezugszeichenliste

| | |
|---|---|
| Wechselstrom leitung | 5 |
| Strommessumformer | 10 |
| Stromsensor | 12 |
| Auswerteelektronik | 14 |
| Spannungsmesser | 16 |
| 1. Ausgangsanschluss | 17 |
| 2. Ausgangsanschluss | 18 |
| Wechselstrom-Last | 20 |
| Steuerungseinrichtung | 24 |
| Wechselstromgenerator | 30 |
| Spule | 32 |
| Widerstand | 34 |
| verschiedene Programmschritte eines Computerprogramms | 50 - 59 |
| Phase | L |
| Neutralleiter | N |
| Strom | I |
| Spannung | U |
| Blindstrom | I_{bL} |
| Wirkstrom | I_{w} |
| Scheitelwert Gesamtstrom | î |
| Scheitelwert Blindstrom | î_{bL} |
| Scheitelwert Wirkstrom | î_{w} |
| Scheitelwert Spannung | û |
| Phasenwinkel | α |
| Phasenverschiebungswinkel | ϕ |

## Patentansprüche

1. Strommessumformer zum Messen des durch einen elektrischen Leiter (L) fließenden Stroms, mit einem Stromsensor (12), der die Stromstärke durch den elektrischen Leiter (L) erfasst und einer Auswerteeinrichtung (14) zur Auswertung der mit dem Stromsensor (12) erfassten Messwerte, und zur Energieflussrichtungsbestimmung, **dadurch gekennzeichnet, dass** in Abhängigkeit der bestimmten Energieflussrichtung eine Ausgabe der Stromstärke in einem positiven oder negativen Ausgabebereich einer Ausgabeeinheit erfolgt, und
mit einem Spannungsmesser (16), der die Spannung auf dem elektrischen Leiter (L) erfasst, bei dem die Bestimmung der Energieflussrichtung durch Auswertung der Messwerte von Strom und Spannung so erfolgt, dass eine Phasenverschiebungswinkelbestimmung für die Phasenverschiebung zwischen Spannung und Strom erfolgt und wobei eine Ausgabe der Stromstärke in dem positiven Ausgabebereich erfolgt, wenn der Phasenverschiebungswinkel (ϕ) im Bereich von -90° bis +90° liegt und anderenfalls eine Ausgabe der Stromstärke in dem negativen Ausgabebereich erfolgt.

2. Strommessumformer nach Anspruch 1, wobei die Ausgabe der Stromstärke in dem positiven und negativen Ausgabebereich proportional erfolgt, wobei der jeweilige Ausgabebereich so definiert ist, dass der Ausgangsstrom proportional zum Messstrom durch den Nullpunkt läuft.

3. Strommessumformer nach Anspruch 2, wobei die Auswerteeinrichtung (14) das Ausgabesignal für den erfassten Messstrom so erzeugt, dass entlang der Ordinate entsprechend der bestimmten Energieflussrichtung die Ausgabewerte vorzeichenbehaftet ausgebbar sind.

4. Strommessumformer nach Anspruch 1, wobei die Ausgabe des Messstroms immer positiv ist und die Energieflussrichtung über einen weiteren Ausganganschluss (17) ausgebbar ist.

5. Strommessumformer nach Anspruch 4, wobei die Ausgabe des Messstroms immer positiv ist und die Energieflussrichtung über den weiteren Ausganganschluss (17) ausgebbar ist und das Ausgabesignal einen Offsetwert von 4 mA aufweist.

6. Strommessumformer nach einem der vorhergehenden Ansprüche, mit einem oder zwei zusätzlichen Anzeigeelementen, insbesondere Leuchtdioden, die zur Anzeige der Energieflussrichtung dienen.

7. Strommessumformer nach einem der vorhergehenden Ansprüche, wobei statt der Ausgabe des gemessenen Stroms eine Ausgabe in Form einer Spannung proportional zum gemessenen Strom erfolgt.

8. Verfahren zur Ausgabe von Messwerten bei einem Strommessumformer nach einem der vorhergehenden Ansprüche, **dadurch gekennzeichnet, dass** neben der Stromstärke die Energieflussrichtung des durch den elektrischen Leiter (L) fließenden Wechselstroms gemessen wird, und dass die gemessene Stromstärke in Abhängigkeit der bestimmten Energieflussrichtung in einem positiven oder negativen Ausgabebereich einer Ausgabeeinheit ausgegeben wird,
wobei eine Messung der Spannungshöhe der Spannung auf dem elektrischen Leiter (L) durchgeführt wird und die Bestimmung der Energieflussrichtung durch Auswertung der Messwerte von Strom und Spannung durchgeführt wird, wobei eine Phasenverschiebungswinkelbestimmung für die Phasenverschiebung zwischen Spannung und Strom durchgeführt wird und die gemessene Stromstärke in dem positiven Ausgabebereich ausgegeben wird, wenn der Phasenverschiebungswinkel (ϕ) im Bereich von 90° bis +90° liegt und anderenfalls die Stromstärke in dem negativen Ausgabebereich ausgegeben wird.

9. Verfahren nach Anspruch 8, wobei die Wirkleistung bestimmt wird und statt der gemessenen Stromstärke die gemessene Wirkleistung in dem positiven und negativen Ausgabebereich ausgegeben wird.

10. Verfahren nach Anspruch 8, wobei die Blindleistung bestimmt wird und statt der gemessenen Stromstärke die gemessene Blindleistung in dem positiven und negativen Ausgabebereich ausgegeben wird.

11. Verfahren nach Anspruch 8, wobei die Scheinleistung bestimmt wird und statt der gemessenen Stromstärke die gemessene Scheinleistung in dem positiven Ausgabebereich ausgeben wird.

12. Verfahren nach Anspruch 8, wobei der Leistungsfaktor bestimmt wird und statt der gemessenen Stromstärke der gemessene Leistungsfaktor oder der gemessene Phasenverschiebungswinkel in dem positiven und negativen Ausgabebereich ausgegeben wird.

13. Verfahren nach Anspruch 8, wobei die Frequenz des Wechselstroms gemessen wird und statt der gemessenen Stromstärke die gemessene Frequenz in dem positiven Ausgabebereich ausgegeben wird.

## Claims

1. A current measuring transducer for the measurement of the current flowing through an electrical conductor (L), comprising:
a current sensor (12) that captures the current intensity through the electrical conductor (L) and an evaluation device (14) for the evaluation of the measured values captured by the current sensor (12), and for the determination of the energy flow direction, **characterized in that** the output of the current intensity in a positive or negative output range of an output unit occurs depending on the determined energy flow direction, and
a voltage meter (16) that captures the voltage on the electrical conductor (L), wherein the determination of the energy flow direction is performed by evaluating the measured values of current and voltage such that a determination of the phase shift angle between voltage and current occurs, and wherein an output of the current intensity occurs in the positive output range if the phase shift angle (ϕ) lies in the range from -90° to +90°, otherwise an output of the current intensity occurs in the negative output range.

2. The current measuring transducer according to claim 1, wherein the output of the current intensity in the positive and negative output range occurs proportionally, wherein the respective output range is defined such that the output current runs proportionally to the measured current through the zero point.

3. The current measuring transducer according to claim 2, wherein the evaluation device (14) generates the output signal for the captured measured current such that along the ordinate, according to the determined energy flow direction, the output values can be output with a sign.

4. The current measuring transducer according to claim 1, wherein the output of the measured current is always positive and the energy flow direction can be output through an additional output terminal (17).

5. The current measuring transducer according to claim 4, wherein the output of the measured current is always positive and the energy flow direction can be output through the additional output terminal (17) and the output signal has an offset value of 4 mA.

6. The current measuring transducer according to any of the preceding claims, with one or two additional display elements, particularly light-emitting diodes (LEDs), which serve to display the energy flow direction.

7. The current measuring transducer according to any of the preceding claims, wherein instead of the output of the measured current, an output in the form of a voltage proportional to the measured current occurs.

8. A method for the output of measured values in a current measuring transducer according to any of the preceding claims, **characterized in that** in addition to the current intensity, the energy flow direction of the alternating current flowing through the electrical conductor (L) is measured, and that the measured current intensity is output in a positive or negative output range of an output unit depending on the determined energy flow direction,
wherein a measurement of the voltage amplitude on the electrical conductor (L) is carried out and the determination of the energy flow direction is performed by evaluating the measured values of current and voltage, wherein a determination of the phase shift angle for the phase shift between voltage and current is carried out, and the measured current intensity is output in the positive output range if the phase shift angle (ϕ) lies in the range from 90° to +90°, otherwise the current intensity is output in the negative output range.

9. The method according to claim 8, wherein the active power is determined and instead of the measured current intensity, the measured active power is output in the positive and negative output range.

10. The method according to claim 8, wherein the reactive power is determined and instead of the measured current intensity, the measured reactive power is output in the positive and negative output range.

11. The method according to claim 8, wherein the apparent power is determined and instead of the measured current intensity, the measured apparent power is output in the positive output range.

12. The method according to claim 8, wherein the power factor is determined and instead of the measured current intensity, the measured power factor or the measured phase shift angle is output in the positive and negative output range.

13. The method according to claim 8, wherein the frequency of the alternating current is measured and instead of the measured current intensity, the measured frequency is output in the positive output range.

## Revendications

1. Convertisseur de mesure de courant pour la mesure du courant circulant dans un conducteur électrique (L), comprenant
un capteur de courant (12) qui détecte l'intensité du courant traversant le conducteur électrique (L) et un dispositif d'évaluation (14) pour l'évaluation des valeurs mesurées détectées par le capteur de courant (12) et pour la détermination du sens du flux d'énergie, **caractérisé en ce qu'**en fonction du sens du flux d'énergie déterminé, une sortie de l'intensité du courant dans une plage de sortie positive ou négative d'une unité de sortie a lieu, et
un voltmètre (16) qui détecte la tension sur le conducteur électrique (L), dans lequel la détermination du sens du flux d'énergie se fait par évaluation des valeurs mesurées de courant et de tension de telle sorte qu'une détermination de l'angle de déphasage pour le déphasage entre la tension et le courant a lieu et dans lequel une sortie de l'intensité du courant dans la plage de sortie positive a lieu lorsque l'angle de déphasage (ϕ) est compris entre -90° et +90° et sinon une sortie de l'intensité du courant a lieu dans la plage de sortie négative.

2. Convertisseur de mesure de courant selon la revendication 1, dans lequel la sortie de l'intensité du courant dans la plage de sortie positive et négative a lieu de manière proportionnelle, la plage de sortie respective étant définie de telle sorte que le courant de sortie passe par le point zéro de manière proportionnelle au courant mesuré.

3. Convertisseur de mesure de courant selon la revendication 2, dans lequel le dispositif d'évaluation (14) génère le signal de sortie pour le courant mesuré détecté de telle sorte que les valeurs de sortie peuvent être délivrées avec un signe le long de l'ordonnée en fonction du sens du flux d'énergie déterminé.

4. Convertisseur de mesure de courant selon la revendication 1, dans lequel la sortie du courant mesuré est toujours positive et le sens du flux d'énergie peut être délivré via un autre terminal de sortie (17).

5. Convertisseur de mesure de courant selon la revendication 4, dans lequel la sortie du courant mesuré est toujours positive et le sens du flux d'énergie peut être délivré via l'autre terminal de sortie (17) et le signal de sortie a une valeur d'offset de 4 mA.

6. Convertisseur de mesure de courant selon l'une des revendications précédentes, avec un ou deux éléments d'affichage supplémentaires, notamment des diodes électroluminescentes, qui servent à afficher le sens du flux d'énergie.

7. Convertisseur de mesure de courant selon l'une des revendications précédentes, dans lequel au lieu de la sortie du courant mesuré, une sortie sous forme d'une tension proportionnelle au courant mesuré a lieu.

8. Procédé pour la sortie de valeurs mesurées dans un convertisseur de mesure de courant selon l'une des revendications précédentes, **caractérisé en ce qu'**en plus de l'intensité du courant, le sens du flux d'énergie du courant alternatif circulant dans le conducteur électrique (L) est mesuré, et **en ce que** l'intensité du courant mesurée est délivrée en fonction du sens du flux d'énergie déterminé dans une plage de sortie positive ou négative d'une unité de sortie,
dans lequel une mesure de l'amplitude de la tension sur le conducteur électrique (L) est effectuée et la détermination du sens du flux d'énergie est réalisée par évaluation des valeurs mesurées de courant et de tension, dans lequel une détermination de l'angle de déphasage pour le déphasage entre la tension et le courant est effectuée et l'intensité du courant mesurée est délivrée dans la plage de sortie positive lorsque l'angle de déphasage (ϕ) est compris entre 90° et +90° et sinon l'intensité du courant est délivrée dans la plage de sortie négative.

9. Procédé selon la revendication 8, dans lequel la puissance active est déterminée et au lieu de l'intensité du courant mesurée, la puissance active mesurée est délivrée dans la plage de sortie positive et négative.

10. Procédé selon la revendication 8, dans lequel la puissance réactive est déterminée et au lieu de l'intensité du courant mesurée, la puissance réactive mesurée est délivrée dans la plage de sortie positive et négative.

11. Procédé selon la revendication 8, dans lequel la puissance apparente est déterminée et au lieu de l'intensité du courant mesurée, la puissance apparente mesurée est délivrée dans la plage de sortie positive.

12. Procédé selon la revendication 8, dans lequel le facteur de puissance est déterminé et au lieu de l'intensité du courant mesurée, le facteur de puissance mesuré ou l'angle de déphasage mesuré est délivré dans la plage de sortie positive et négative.

13. Procédé selon la revendication 8, dans lequel la fréquence du courant alternatif est mesurée et au lieu de l'intensité du courant mesurée, la fréquence mesurée est délivrée dans la plage de sortie positive.
